# EUROPEAN PATENT SPECIFICATION

(11) **EP 4 258 541 B1**
(45) Date of publication and mention of the grant of the patent: **05.11.2025**
(21) Application number: 21899560.3
(22) Date of filing: 25.06.2021
(51) Int. Cl.: H02S 30/10

(54) **FULL-SCREEN PHOTOVOLTAIC MODULE FRAME AND ASSEMBLY PROCESS THEREFOR**
VOLLBILDSCHIRMRAHMEN FÜR FOTOVOLTAISCHES MODUL UND MONTAGEVERFAHREN DAFÜR
CADRE DE MODULE PHOTOVOLTAÏQUE PLEIN ÉCRAN ET SON PROCÉDÉ D'ASSEMBLAGE

(30) Priority: 03.12.2020 CN 202011394465
(43) Date of publication of application: 11.10.2023
(73) Proprietor: Anhui Daheng Energy Technology Co., Ltd., Hefei, Anhui 230000 (CN)
(72) Inventor: XIE, Shenheng, Hefei, Anhui 230000 (CN); JIANG, Chengyin, Hefei, Anhui 230000 (CN); ZHENG, Xiaowu, Hefei, Anhui 230000 (CN)
(74) Representative: Cleanthous, Marinos
(86) International application number: PCT/CN2021/102354
(87) International publication number: WO 2022/116518

(56) References cited:
- CN-A- 102 779 877
- CN-A- 111 669 116
- CN-A- 112 422 065
- CN-U- 206 977 373
- CN-U- 207 117 556
- CN-U- 208 539 844
- US-A1- 2014 338 190

## Description

### Technical Field

The present invention relates to a photovoltaic module, and in particular to a full-screen photovoltaic module frame and an assembly process therefor.

### Background Art

At present, the installed capacity of large-scale ground power stations and distributed power stations is increasing year by year, and there are also various types and installation methods of their installed components. Large-scale ground power stations and most of the distributed power stations use traditional frame schemes to meet the requirement of the service life of the installed components of 25 years or more under water vapor and load tests by means of technologies such as anodic oxidation, hot-dip galvanizing and anti-UV. Large-scale ground (photovoltaic) power stations generally have a large installed capacity, a large installation workload, and complex operation and maintenance. In contrast, distributed (photovoltaic) power stations are favored by household customers, and distributed power stations impose more stringent requirements on the components than conventional components in terms of appearance and electrical performance. CN 207117556 U discloses a full-screen photovoltaic module frame.

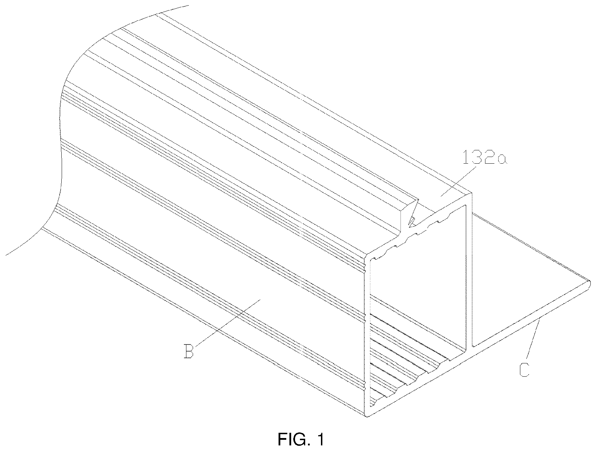

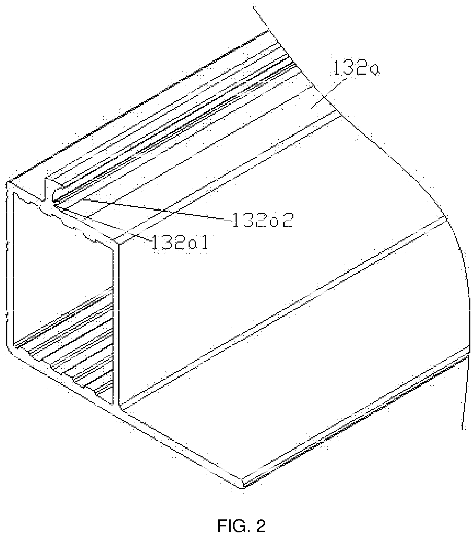

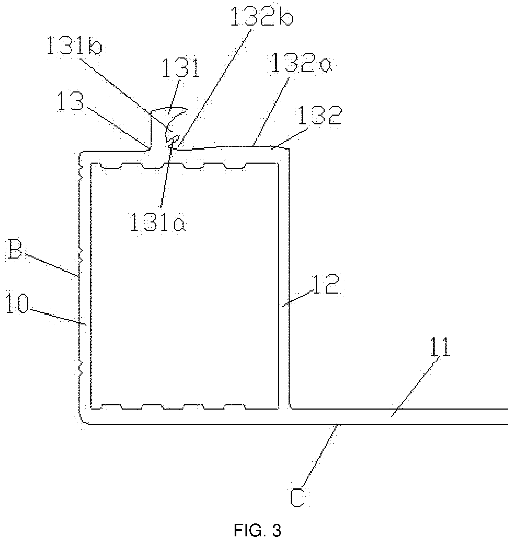

The earlier application of Chinese patent "New-type photovoltaic module frame" with the application no. 202021962623.4 filed by the applicant discloses a photovoltaic module frame ("referring to FIGS. 3 and 4" for the prior art in the background art is wrong, and should be "referring to FIGS. 1 and 2"), which solves the problems of conventional photovoltaic modules that it is impossible to observe overflowing silica gel during assembly due to the presence of side A and that it is easy to form dirt on an inner side of the side A to cover a photovoltaic module panel, which affects power generation and even causes hot spots. However, such a frame structure is still complicated. In addition to high difficulty in machining process and high production cost, the user needs to apply silica gel in both a bottom face silica gel overflow groove and a side face silica gel overflow groove of the frame during assembly. Since silica gel is applied in multiple positions directly, the assembly process has many procedures and is low in efficiency and high in machining cost. In addition, since silica gel is applied in multiple positions, in addition to difficult control on the silica gel application control amount, multiple silica gel overflow groove cavities are provided correspondingly, resulting in large silica gel overflow amount, so that the effect of controlling the silica gel overflow amount still needs to be improved.

### Summary of the Invention

### Technical Problems

The objective of the present invention is to provide a full-screen photovoltaic module frame and an assembly process therefor, which solves the problems in the background art and achieves a simpler frame structure, lowered machining difficulty and a reduced production cost. Moreover, the assembly process is simple, the assembly efficiency is high, the assembly cost is reduced, the silica gel overflow control effect is better, and the applicability is improved.

### Solutions to the Problems

### Technical Solutions

In order to achieve the above objective, the present invention uses the following technical solutions. A full-screen photovoltaic module frame comprises a main frame member arranged surrounding a photovoltaic module, the main frame member comprising a bottom flat support, a middle connection frame support, and a top supporting frame support, which are sequentially arranged from the inside out, the top supporting frame support comprising a bottom face supporting portion and a side face enclosing portion, with an upper end of the side face enclosing portion being flush with an outer surface of the photovoltaic module. The bottom face supporting portion comprises a silica gel dispensing portion arranged close to an inner side supporting frame edge of the middle connection frame support, the silica gel dispensing portion is a flat surface protruding from both sides, a silica gel storage cavity is formed between the silica gel dispensing portion and an inner side of a lower portion of the side face enclosing portion, a silica gel overflow cavity is provided above the silica gel storage cavity, and the full-screen photovoltaic module frame is provided with only one silica gel overflow cavity.

Further, a middle segment of an inner side of the side face enclosing portion is provided with a silica gel overflow barrier rod, a free end of the silica gel overflow barrier rod is inclined to the photovoltaic module, a gap is formed between the free end and the photovoltaic module, the silica gel storage cavity is located below the silica gel overflow barrier rod, and the silica gel overflow cavity is located above the silica gel overflow barrier rod.

Still further, the silica gel storage portion comprises a first V-groove that is located on an inner side of the silica gel dispensing portion and has an opening facing the silica gel overflow barrier rod and a second V-groove that is located on an inner side of the first V-groove and has an opening facing the silica gel dispensing portion.

Still further, the bottom flat support, the middle connection frame support and the top supporting frame support are of an integrated structure.

An assembly process for a full-screen photovoltaic module frame comprises the following steps. 1) Silica gel dispensing is carried out for a frame, in which an outer side supporting frame edge of the middle connection frame support of the photovoltaic module frame is placed flat on a worktable, a silica gel dispensing head is aligned to the silica gel dispensing portion, and the dispensing head is moved to evenly dispense silica gel in a lengthwise direction of the silica gel dispensing portion.

2) The frame is transferred, in which a clamping mechanism clamps the outer side supporting frame edge of the middle connection frame support or the bottom flat support of the frame to transfer the frame to a frame assembly position and fix the frame.

3) The frame is assembled, in which the frame and a photovoltaic module laminate are respectively fixed such that the photovoltaic module laminate is placed flat on the inner side of the side face enclosing portion 131 of the frame, the relative height of the frame and the photovoltaic module laminate is adjusted such that the frame is higher than the photovoltaic module laminate, and the frame is gradually pressed inwards until the frame comes into contact with the photovoltaic module laminate, such that the silica gel dispensing portion of the frame is attached to an inner surface of the photovoltaic module laminate, and the upper end of the side face enclosing portion of the frame is closely fitted and flush with an outer surface of the photovoltaic module laminate.

4) After the photovoltaic module laminate and the frame are assembled in step 3), a uniform pressure directed to the photovoltaic module laminate is applied on the frame surrounding the photovoltaic module laminate.

5) Refixing is carried out, in which the photovoltaic module laminate and the frame are refixed; and a finished photovoltaic module is formed and cured in a curing room.

Further, the frame being higher than the photovoltaic module laminate in step 3) means that the upper end of the side face enclosing portion of the frame is higher than the outer surface of the photovoltaic module laminate.

Further, the pressure in step 4) comprises a force perpendicular to a laminate side of the photovoltaic module laminate and a force parallel to the laminate side of the photovoltaic module laminate.

Further, the refixing in step 5) comprises screw fixing between the frames.

### Beneficial Effects of the Invention

### Beneficial Effects

In the frame of the present invention, the middle connection frame support is provided with a silica gel dispensing portion parallel to the photovoltaic module, the silica gel dispensing portion is an elongate flat surface, and the silica gel dispensing head is directly aligned to the silica gel dispensing portion for one-step silica gel dispensing, so that the procedure is simpler than the prior art, and the existing structure of pouring silica gel into a groove (a silica gel overflow groove) is omitted, which directly reduces the process difficulty and reduces the silica gel dispensing amount, so that the silica gel overflow amount is small, the silica gel overflow amount is well controlled, the machining difficulty is directly lowered, and the cost of machining the photovoltaic module is greatly reduced. In addition, for the frame of the present invention, it is not necessary to groove in multiple positions and further provide a top supporting structure, so that the machining difficulty of the frame itself is lowered, and the production cost is reduced. When the frame and the photovoltaic module are assembled, since the frame and each side of the photovoltaic module move towards each other, most of the silica gel in the silica gel dispensing portion that is formed by pressing the frame is forced into the silica gel storage cavity and temporarily stored in the silica gel storage cavity, and the overflow amount of silica gel overflows to the silica gel overflow cavity, so that the side face of the photovoltaic module is bonded by means of the silica gel forced into the silica gel storage cavity, and the overflowing silica gel in the silica gel overflow cavity can assist bonding and fixing of glass of the photovoltaic module, with the overflowing silica gel being absorbed; and a few silica gel is forced to the lower part of the silica gel dispensing portion close to the inner side supporting frame edge of the middle connection frame support so as to form inner side bonding without affecting the appearance of the photovoltaic module. According to the present invention, the structure of the frame is simpler, the machining difficulty is lowered, and the production cost is reduced. Moreover, the assembly process is simple, the assembly efficiency is high, the assembly cost is reduced, the silica gel overflow control effect is better, and the applicability is improved.

### Brief Description of the Drawings

### Brief Description of the Drawings

FIG. 1 is a structural view from one perspective of a frame according to the present invention.
FIG. 2 is a structural view from another perspective of the frame according to the present invention.
FIG. 3 is a front structural view of the frame according to the present invention.

### Preferred Embodiments implementing the Invention

### Preferred Implementations of the Invention

The technical solutions in the embodiments of the present invention will be clearly and completely described below with reference to the accompanying drawings in the embodiments of the present invention. Obviously, the embodiments described are merely some rather than all of the embodiments of the present invention. On the basis of the embodiments of the present invention, all other embodiments obtained by those of ordinary skill in the art without involving any inventive efforts shall fall within the scope of protection of the present invention.

The present invention provides a full-screen photovoltaic module frame and an assembly process therefor, which are applicable to a frame without side A.

A full-screen photovoltaic module frame of the present invention comprises a main frame member 10 arranged surrounding a photovoltaic module, the main frame member 10 comprising a bottom flat support 11, a middle connection frame support 12, and a top supporting frame support 13, which are sequentially arranged from the inside out, the top supporting frame support 13 comprising a bottom face supporting portion 132 and a side face enclosing portion 131, with an upper end of the side face enclosing portion 131 being flush with an outer surface of the photovoltaic module. The bottom face supporting portion 132 comprises a silica gel dispensing portion 132a arranged close to an inner side supporting frame edge of the middle connection frame support 12, the silica gel dispensing portion 132a is a flat surface protruding from both sides, a silica gel storage cavity 132b is formed between the silica gel dispensing portion 132a and an inner side of a lower portion of the side face enclosing portion 131, a silica gel overflow cavity 131b is provided above the silica gel storage cavity 132b, and the full-screen photovoltaic module frame is provided with only one silica gel overflow cavity.

Further, a middle segment of an inner side of the side face enclosing portion 131 is provided with a silica gel overflow barrier rod 131a, a free end of the silica gel overflow barrier rod 131a is inclined to the photovoltaic module, a gap is formed between the free end and the photovoltaic module, the silica gel storage cavity 132b is located below the silica gel overflow barrier rod 131a, and the silica gel overflow cavity 131b is located above the silica gel overflow barrier rod 131a.

Still further, the silica gel storage portion 132b comprises a first V-groove 132a1 that is located on an inner side of the silica gel dispensing portion 132a and has an opening facing the silica gel overflow barrier rod 131a and a second V-groove 132a2 that is located on an inner side of the first V-groove 132a1 and has an opening facing the silica gel dispensing portion 132a.

Still further, the bottom flat support 11, the middle connection frame support 12 and the top supporting frame support 13 are of an integrated structure.

An assembly process for a full-screen photovoltaic module frame comprises the following steps. 1) Silica gel dispensing is carried out for a frame, in which an outer side supporting frame edge of the middle connection frame support 12 of the photovoltaic module frame is placed flat on a worktable, a silica gel dispensing head is aligned to the silica gel dispensing portion 132a, and the dispensing head is moved to evenly dispense silica gel in a lengthwise direction of the silica gel dispensing portion 132a.

2) The frame is transferred, in which a clamping mechanism clamps the outer side supporting frame edge (side B in the figure) of the middle connection frame support 12 or the bottom flat support 11 (side C in the figure) of the frame to transfer the frame to a frame assembly position and fix the frame.

In this way, it is possible to prevent the mechanism from coming into contact with the silica gel.

3) The frame is assembled, in which the frame and a photovoltaic module laminate are respectively fixed such that the photovoltaic module laminate is placed flat on the inner side of the side face enclosing portion 131 of the frame, the relative height of the frame and the photovoltaic module laminate is adjusted such that the frame is higher than the photovoltaic module laminate, and the frame is gradually pressed inwards until the frame comes into contact with the photovoltaic module laminate, such that the silica gel dispensing portion 132a of the frame is attached to an inner surface of the photovoltaic module laminate, and the upper end of the side face enclosing portion 131 of the frame is closely fitted and flush with an outer surface of the photovoltaic module laminate.

4) After the photovoltaic module laminate and the frame are assembled in step 3), a uniform pressure directed to the photovoltaic module laminate is applied on the frame surrounding the photovoltaic module laminate. In this way, the silica gel between the frame and the photovoltaic module is evenly dispersed in shape and distribution, thereby achieving better bonding.

5) Refixing is carried out, in which the photovoltaic module laminate and the frame are refixed; and a finished photovoltaic module is formed and cured in a curing room.

The photovoltaic module laminate mentioned above is the product of the forgoing photovoltaic module before extrusion molding.

Further, the frame being higher than the photovoltaic module laminate in step 3) means that the upper end of the side face enclosing portion 131 of the frame is higher than the outer surface of the photovoltaic module laminate.

Further, the pressure in step 4) comprises a force perpendicular to a laminate side of the photovoltaic module laminate and a force parallel to the laminate side of the photovoltaic module laminate.

Further, the refixing in step 5) comprises screw fixing between the frames.

### Embodiments of the Invention

### Implementations of the Invention

In the frame of the present invention, the middle connection frame support 12 is provided with a silica gel dispensing portion 132a parallel to the photovoltaic module, referring to the figures, the silica gel dispensing portion 132a is an elongate flat surface, and the silica gel dispensing head is directly aligned to the silica gel dispensing portion 132a for one-step silica gel dispensing, so that the procedure is simpler than the prior art, and the existing structure of pouring silica gel into a groove (a silica gel overflow groove) is omitted, which directly reduces the process difficulty and reduces the silica gel dispensing amount, so that the silica gel overflow amount is small, the silica gel overflow amount is well controlled, the machining difficulty is directly lowered, and the cost of machining the photovoltaic module is greatly reduced. In addition, for the frame of the present invention, it is not necessary to groove in multiple positions and further provide a top supporting structure, so that the machining difficulty of the frame itself is lowered, and the production cost is reduced. When the frame and the photovoltaic module are assembled, since the frame and each side of the photovoltaic module move towards each other, most of the silica gel in the silica gel dispensing portion 132a that is formed by pressing the frame is forced into the silica gel storage cavity 132b and temporarily stored in the silica gel storage cavity 132b, and the overflow amount of silica gel overflows to the silica gel overflow cavity 131b, so that the side face of the photovoltaic module is bonded by means of the silica gel forced into the silica gel storage cavity 132b, and the overflowing silica gel in the silica gel overflow cavity 131b can assist bonding and fixing of glass of the photovoltaic module, with the overflowing silica gel being absorbed; and a few silica gel is forced to the lower part of the silica gel dispensing portion 132a close to the inner side supporting frame edge of the middle connection frame support 12 so as to form inner side bonding without affecting the appearance of the photovoltaic module. According to the present invention, the structure of the frame is simpler, the machining difficulty is lowered, and the production cost is reduced. Moreover, the assembly process is simple, the assembly efficiency is high, the assembly cost is reduced, the silica gel overflow control effect is better, and the applicability is improved.

## Claims

1. A full-screen photovoltaic module frame, comprising a main frame member (10) arranged surrounding a photovoltaic module, the main frame member (10) comprising a bottom flat support (11), a middle connection frame support (12), and a top supporting frame support (13), which are sequentially arranged from the inside out, the top supporting frame support (13) comprising a bottom face supporting portion (132) and a side face enclosing portion (131), with an upper end of the side face enclosing portion (131) being flush with an outer surface of the photovoltaic module, **characterized in that** the bottom face supporting portion (132) comprises a silica gel dispensing portion (132a) arranged close to an inner side supporting frame edge of the middle connection frame support (12), the silica gel dispensing portion (132a) is a flat surface protruding from both sides, a silica gel storage cavity (132b) is formed between the silica gel dispensing portion (132a) and an inner side of a lower portion of the side face enclosing portion (131), a silica gel overflow cavity (131b) is provided above the silica gel storage cavity (132b), and the full-screen photovoltaic module frame is provided with only one silica gel overflow cavity.

2. The full-screen photovoltaic module frame according to claim 1, **characterized in that** a middle segment of an inner side of the side face enclosing portion (131) is provided with a silica gel overflow barrier rod (131a), a free end of the silica gel overflow barrier rod (131a) is inclined to the photovoltaic module, a gap is formed between the free end and the photovoltaic module, the silica gel storage cavity (132b) is located below the silica gel overflow barrier rod (131a), and the silica gel overflow cavity (131b) is located above the silica gel overflow barrier rod (131a).

3. The full-screen photovoltaic module frame according to claim 2, **characterized in that** the silica gel storage portion (132b) comprises a first V-groove (132a1) that is located on an inner side of the silica gel dispensing portion (132a) and has an opening facing the silica gel overflow barrier rod (131a) and a second V-groove (132a2) that is located on an inner side of the first V-groove (132a1) and has an opening facing the silica gel dispensing portion (132a).

4. The full-screen photovoltaic module frame according to claim 1, 2 or 3, **characterized in that** the bottom flat support (11), the middle connection frame support (12) and the top supporting frame support (13) are of an integrated structure.

5. An assembly process using a full-screen photovoltaic module frame of any one of claims 1-4, **characterized by** comprising the following steps:
1) dispensing silica gel for a frame, in which an outer side supporting frame edge of the middle connection frame support (12) of the photovoltaic module frame is placed flat on a worktable, a silica gel dispensing head is aligned to the silica gel dispensing portion (132a), and the dispensing head is moved to evenly dispense silica gel in a lengthwise direction of the silica gel dispensing portion (132a);
2) transferring the frame, in which a clamping mechanism clamps the outer side supporting frame edge of the middle connection frame support (12) or the bottom flat support (11) of the frame to transfer the frame to a frame assembly position and fix the frame;
3) assembling the frame, in which the frame and a photovoltaic module laminate are respectively fixed such that the photovoltaic module laminate is placed flat on the inner side of the side face enclosing portion (131) of the frame, the relative height of the frame and the photovoltaic module laminate is adjusted such that the frame is higher than the photovoltaic module laminate, and the frame is gradually pressed inwards until the frame comes into contact with the photovoltaic module laminate, such that the silica gel dispensing portion (132a) of the frame is attached to an inner surface of the photovoltaic module laminate, and the upper end of the side face enclosing portion (131) of the frame is closely fitted and flush with an outer surface of the photovoltaic module laminate;
4) after the photovoltaic module laminate and the frame are assembled in step 3), applying a uniform pressure, which is directed to the photovoltaic module laminate, on the frame surrounding the photovoltaic module laminate; and
5) refixing, in which the photovoltaic module laminate and the frame are refixed; and a finished photovoltaic module is formed and cured in a curing room.

6. The assembly process for a full-screen photovoltaic module frame according to claim 5, **characterized in that** the frame being higher than the photovoltaic module laminate in step 3) means that the upper end of the side face enclosing portion (131) of the frame is higher than the outer surface of the photovoltaic module laminate.

7. The assembly process for a full-screen photovoltaic module frame according to claim 5, **characterized in that** the pressure in step 4) comprises a force perpendicular to a laminate side of the photovoltaic module laminate and a force parallel to the laminate side of the photovoltaic module laminate.

8. The assembly process for a full-screen photovoltaic module frame according to claim 5, **characterized in that** the refixing in step 5) comprises screw fixing between the frames.

## Patentansprüche

1. Vollbild-Photovoltaikmodulrahmen, umfassend ein Hauptrahmenelement (10), das um ein Photovoltaikmodul herum angeordnet ist, wobei das Hauptrahmenelement (10) eine untere flache Stütze (11), eine mittlere Verbindungsrahmenstütze (12) und eine obere Stützrahmenstütze (13) umfasst, die von innen nach außen nacheinander angeordnet sind, wobei die obere Stützrahmenstütze (13) einen Bodenflächen-Stützabschnitt (132) und einen Seitenflächen-Umschließungsabschnitt (131) umfasst, wobei ein oberes Ende des Seitenflächen-Umschließungsabschnitts (131) bündig mit einer Außenfläche des Photovoltaikmoduls ist, **dadurch gekennzeichnet, dass** der Bodenflächen-Stützabschnitt (132) einen Silikonauftragabschnitt (132a) umfasst, der nahe an einer inneren Seitenstützrahmenkante der mittleren Verbindungsrahmenstütze (12) angeordnet ist, wobei der Silikonauftragabschnitt (132a) eine von beiden Seiten hervorstehende Flachfläche ist, wobei ein Silikonvorratshohlraum (132b) zwischen dem Silikonauftragabschnitt (132a) und einer Innenseite eines unteren Abschnitts des Seitenflächen-Umschließungsabschnitts (131) ausgebildet ist, wobei oberhalb des Silikonvorratshohlraums (132b) ein Silikonüberlaufhohlraum (131b) vorgesehen ist, und wobei der Vollbild-Photovoltaikmodulrahmen nur mit einem einzigen Silikonüberlaufhohlraum versehen ist.

2. Vollbild-Photovoltaikmodulrahmen nach Anspruch 1, **dadurch gekennzeichnet, dass** ein mittlerer Abschnitt einer Innenseite des Seitenflächen-Umschließungsabschnitts (131) mit einer Silikon-Überlaufbarrierestange (131a) versehen ist, wobei ein freies Ende der Silikon-Überlaufbarrierestange (131a) zum Photovoltaikmodul geneigt ist, wobei ein Spalt zwischen dem freien Ende und dem Photovoltaikmodul ausgebildet ist, wobei der Silikonvorratshohlraum (132b) sich unterhalb der Silikon-Überlaufbarrierestange (131a) befindet und der Silikonüberlaufhohlraum (131b) sich oberhalb der Silikon-Überlaufbarrierestange (131a) befindet.

3. Vollbild-Photovoltaikmodulrahmen nach Anspruch 2, **dadurch gekennzeichnet, dass** der Silikonvorratsabschnitt (132b) eine erste V-Nut (132a1) umfasst, die sich an einer Innenseite des Silikonauftragabschnitts (132a) befindet und deren Öffnung zur Silikon-Überlaufbarrierestange (131a) weist, und eine zweite V-Nut (132a2) umfasst, die sich an einer Innenseite der ersten V-Nut (132a1) befindet und deren Öffnung zum Silikonauftragabschnitt (132a) weist.

4. Vollbild-Photovoltaikmodulrahmen nach Anspruch 1, 2 oder 3, **dadurch gekennzeichnet, dass** der untere flache Stütze (11), der mittlere Verbindungsrahmenstütze (12) und der obere Stützrahmenstütze (13) eine integrierte Struktur aufweisen.

5. Montageverfahren unter Verwendung eines
Vollbild-Photovoltaikmodulrahmens nach einem der Ansprüche 1 bis 4, **dadurch gekennzeichnet, dass** es die folgenden Schritte umfasst:
1) Auftragen von Silikon für einen Rahmen, wobei eine äußere Seitenstützrahmenkante der mittleren Verbindungsrahmenstütze (12) des Photovoltaikmodulrahmens flach auf einem Arbeitstisch abgelegt wird, ein Silikonauftragkopf auf den Silikonauftragabschnitt (132a) ausgerichtet wird und der Silikonauftragkopf bewegt wird, um Silikon gleichmäßig in Längsrichtung des Silikonauftragabschnitts (132a) aufzutragen;
2) Überführen des Rahmens, wobei ein Klemmmechanismus die äußere Seitenstützrahmenkante der mittleren Verbindungsrahmenstütze (12) oder die untere flache Stütze (11) des Rahmens klemmt, um den Rahmen zu einer Rahmenmontageposition zu überführen und den Rahmen zu fixieren;
3) Zusammenbauen des Rahmens, wobei der Rahmen und ein Photovoltaikmodul-Laminat jeweils derart befestigt werden, dass das Photovoltaikmodul-Laminat flach auf der Innenseite des Seitenflächen-Umschließungsabschnitts (131) des Rahmens angeordnet wird, wobei das relative Höhenverhältnis des Rahmens und des Photovoltaikmodul-Laminats derart eingestellt wird, dass der Rahmen höher als das Photovoltaikmodul-Laminat ist, und wobei der Rahmen allmählich nach innen gedrückt wird, bis der Rahmen mit dem Photovoltaikmodul-Laminat in Kontakt kommt, sodass der Silikonauftragabschnitt (132a) des Rahmens an einer Innenfläche des Photovoltaikmodul-Laminats anliegt, und wobei das obere Ende des Seitenflächen-Umschließungsabschnitts (131) des Rahmens eng anliegend und bündig mit einer Außenfläche des Photovoltaikmodul-Laminats abschließt;
4) nachdem das Photovoltaikmodul-Laminat und der Rahmen in Schritt 3) zusammengebaut sind, Ausüben eines gleichmäßigen Drucks, der auf das Photovoltaikmodul-Laminat gerichtet ist, auf den den Photovoltaikmodul-Laminat umgebenden Rahmen; und
5) erneutes Befestigen, wobei das Photovoltaikmodul-Laminat und der Rahmen wieder befestigt werden; und ein fertiges Photovoltaikmodul gebildet und in einem Aushärteraum ausgehärtet wird .

6. Montageverfahren für einen Vollbild-Photovoltaikmodulrahmen gemäß Anspruch 5, **dadurch gekennzeichnet, dass** das höher als das Photovoltaikmodul-Laminat befindliche Rahmen in Schritt 3) bedeutet, dass das obere Ende des Seitenflächen-Umschließungsabschnitts (131) des Rahmens höher als die Außenfläche des Photovoltaikmodul-Laminats ist.

7. Montageverfahren für einen Vollbild-Photovoltaikmodulrahmen gemäß Anspruch 5, **dadurch gekennzeichnet, dass** der Druck in Schritt 4) eine Kraft , die senkrecht zu einer Laminatseite des Photovoltaikmodul-Laminats wirkt, und eine Kraft, die parallel zu der Laminatseite des Photovoltaikmodul-Laminats wirkt, umfasst.

8. Montageverfahren für einen Vollbild-Photovoltaikmodulrahmen gemäß Anspruch 5, **dadurch gekennzeichnet, dass** das erneute Befestigen in Schritt 5) eine Schraubbefestigung zwischen den Rahmen umfasst.

## Revendications

1. Cadre de module photovoltaïque plein écran, comprenant un élément de cadre principal (10) disposé autour d'un module photovoltaïque, l'élément de cadre principal (10) comprenant un support plat inférieur (11), un support de cadre de liaison intermédiaire (12) et un support de cadre de soutien supérieur (13), qui sont disposés séquentiellement de l'intérieur vers l'extérieur, le support de cadre de soutien supérieur (13) comprenant une partie de soutien de face inférieure (132) et une partie de confinement de face latérale (131), une extrémité supérieure de la partie de confinement de face latérale (131) étant à fleur d'une surface externe du module photovoltaïque, **caractérisé en ce que** la partie de soutien de face inférieure (132) comprend une partie de distribution de gel de silice (132a) disposée à proximité d'un bord de soutien de cadre latéral interne du support de cadre de liaison intermédiaire (12), la partie de distribution de gel de silice (132a) est une surface plane faisant saillie de deux côtés, une cavité de stockage de gel de silice (132b) est formée entre la partie de distribution de gel de silice (132a) et un côté interne d'une partie inférieure de la partie de confinement de face latérale (131), une cavité de débordement en gel de silice (131b) est prévue au-dessus de la cavité de stockage de gel de silice (132b), et le cadre de module photovoltaïque plein écran est pourvu d'une seule cavité de débordement en gel de silice.

2. Cadre de module photovoltaïque plein écran selon la revendication 1, **caractérisé en ce qu'**un segment central d'un côté interne de la partie de confinement de face latérale (131) est pourvu d'une tige de barrière anti-débordement en gel de silice (131a), une extrémité libre de la tige de barrière anti-débordement en gel de silice (131a) est inclinée vers le module photovoltaïque, un espace est formé entre l'extrémité libre et le module photovoltaïque, la cavité de stockage de gel de silice (132b) est située au-dessous de la tige de barrière anti-débordement en gel de silice (131a), et la cavité de débordement en gel de silice (131b) est située au-dessus de la tige de barrière anti-débordement en gel de silice (131a).

3. Cadre de module photovoltaïque plein écran selon la revendication 2, **caractérisé en ce que** la partie de stockage de gel de silice (132b) comprend une première rainure en forme de V (132a1) qui est située sur un côté interne de la partie de distribution de gel de silice (132a) et présente une ouverture faisant face à la tige de barrière anti-débordement en gel de silice (131a), et une seconde rainure en forme de V (132a2) qui est située sur un côté interne de la première rainure en forme de V (132a1) et présente une ouverture faisant face à la partie de distribution de gel de silice (132a).

4. Cadre de module photovoltaïque plein écran selon la revendication 1, 2 ou 3, **caractérisé en ce que** le support plat inférieur (11), le support de cadre de liaison intermédiaire (12) et le support de cadre de soutien supérieur (13) forment une structure intégrée.

5. Procédé d'assemblage à l'aide d'un cadre de module photovoltaïque plein écran selon l'une quelconque des revendications 1 à 4, **caractérisé en ce qu'**il comprend les étapes suivantes consistant à :
1) distribuer du gel de silice pour un cadre, dans lequel un bord de cadre de soutien latéral externe du support de cadre de liaison intermédiaire (12) du cadre de module photovoltaïque est placé à plat sur une table de travail, une tête de distribution de gel de silice est alignée avec la partie de distribution de gel de silice (132a), et la tête de distribution est déplacée pour distribuer uniformément du gel de silice dans une direction longitudinale de la partie de distribution de gel de silice (132a) ;
2) transférer le cadre, dans lequel un mécanisme de serrage serre le bord de cadre de soutien latéral externe du support de cadre de liaison intermédiaire (12) ou le support plat inférieur (11) du cadre afin de transférer le cadre vers une position d'assemblage de cadre et de fixer le cadre ;
3) assembler le cadre, dans lequel le cadre et un stratifié de module photovoltaïque sont respectivement fixés de telle sorte que le stratifié de module photovoltaïque soit placé à plat sur le côté interne de la partie de confinement de face latérale (131) du cadre, la hauteur relative du cadre et du stratifié de module photovoltaïque est ajustée de telle sorte que le cadre soit plus haut que le stratifié de module photovoltaïque, et le cadre est progressivement pressé vers l'intérieur jusqu'à ce que le cadre entre en contact avec le stratifié de module photovoltaïque, de telle sorte que la partie de distribution de gel de silice (132a) du cadre soit fixée à une surface interne du stratifié de module photovoltaïque, et que l'extrémité supérieure de la partie de confinement de face latérale (131) du cadre soit étroitement ajustée sur et à fleur d'une surface externe du stratifié de module photovoltaïque ;
4) après l'assemblage du stratifié de module photovoltaïque et du cadre à l'étape 3), appliquer une pression uniforme, qui est dirigée vers le stratifié de module photovoltaïque, sur le cadre entourant le stratifié de module photovoltaïque ; et
5) effectuer la refixation, dans lequel le stratifié de module photovoltaïque et le cadre sont refixés ; et un module photovoltaïque fini est formé et durci dans une chambre de durcissement.

6. Procédé d'assemblage d'un cadre de module photovoltaïque plein écran selon la revendication 5, **caractérisé en ce que** le cadre qui est plus haut que le stratifié de module photovoltaïque à l'étape 3) signifie que l'extrémité supérieure de la partie de confinement de face latérale (131) du cadre est plus haute que la surface externe du stratifié de module photovoltaïque.

7. Procédé d'assemblage d'un cadre de module photovoltaïque plein écran selon la revendication 5, **caractérisé en ce que** la pression à l'étape 4) comprend une force perpendiculaire à un côté de stratifié du stratifié de module photovoltaïque et une force parallèle au côté de stratifié du stratifié de module photovoltaïque.

8. Procédé d'assemblage d'un cadre de module photovoltaïque plein écran selon la revendication 5, **caractérisé en ce que** la refixation à l'étape 5) comprend une fixation par vis entre les cadres.
